# EUROPEAN PATENT SPECIFICATION

(11) **EP 1 933 335 B1**
(45) Date of publication and mention of the grant of the patent: **20.06.2018**
(21) Application number: 06797641.5
(22) Date of filing: 07.09.2006
(51) Int. Cl.: H01B 13/00, H01B 12/06, H01F 6/06, H01L 39/24, H01L 39/14

(54) **METHOD FOR MANUFACTURING SUPERCONDUCTING TAPE WIRE ROD, SUPERCONDUCTING TAPE WIRE ROD, AND SUPERCONDUCTING DEVICE**
VERFAHREN ZUR HERSTELLUNG VON SUPRALEITENDEM BANDWALZDRAHT, SUPRALEITENDER BANDWALZDRAHT UND SUPRALEITENDE VORRICHTUNG
FIL ROND POUR BANDE SUPERCONDUCTRICE ET SON PROCEDE DE FABRICATION ET DISPOSITIF SUPERCONDUCTEUR

(30) Priority: 21.09.2005 JP 2005274235
(43) Date of publication of application: 18.06.2008
(73) Proprietor: Sumitomo Electric Industries, Ltd., Osaka-shi, Osaka 541-0041 (JP)
(72) Inventor: OHMATSU, Kazuya, Osaka-shi, Osaka (JP)
(74) Representative: Kreutzer, Ulrich
(86) International application number: PCT/JP2006/317781
(87) International publication number: WO 2007/034686

(56) References cited:
- JP-A- 63 207 007
- JP-A- 63 207 007
- US-A- 6 153 825

## Description

### Technical Field

The present invention relates to a method of manufacturing a superconducting tape wire.

### Background Art

Heretofore, a Bi-based high temperature superconducting wire has been used for strong magnetic coils. In addition, in recent years, a thin Y-based high temperature superconducting tape wire has been used in some cases. In addition, a nuclear magnetic resonance (NMR) coil at a frequency of 900 to 920 MHz has been formed using a superconductive metal wire. A long uniform wire is necessary for making a NMR coil such as described above.

As for a method of manufacturing a long wire having uniform properties, Japanese Patent Application Publication No. H 6-120025 (Patent Document 1) discloses a method of manufacturing an oxide superconducting coil. According to the method disclosed in Patent Document 1, a film of an oxide superconducting material is formed on a nonsuperconductive substrate, which has a helicoid continuous surface such that when a line straightly connecting an inner diameter and an outer shape with respect to the center axis of a coil, which is made from the substrate, rotates around the center axis of the coil, the intersection between the straight line and the center axis moves in the top and bottom direction of the center axis.
Patent Document 1: Japanese Patent Application Publication No. H6-120025

However, in order to form an NMR coil of 1 GHz frequency, for example, in the case of a B (bismuth)-based wire having a Bi-2212 composition, a long wire having a unit length of 1,600 m is necessary when a round wire having an outer diameter of 1 mm is used under the conditions in which the temperature is 4.2K, the magnetic flux density is 25 T, and Ic (critical current) is 300 A. Also, in the case of a Y-based thin wire, a wire having a unit length of 500 m is necessary when a tape wire having a width of 1 cm is used under the same conditions as those described above. Hence, when a coil is formed using a superconducting wire, a long wire having uniform properties is necessary. In particular, when a strong magnetic coil is formed, the wire as described above is required.

However, with respect to the above superconducting wires, it is difficult to form such a long wire as described above. In addition, even if such a long wire as described above is realized, the manufacturing cost would be very high, and hence the problem is that the production of such a long wire as a commercial product would be very difficult.

With the method disclosed in Patent Document 1 for manufacturing an oxide superconducting coil, it might be possible to produce a long wire since a film made from an oxide superconducting material is formed on the nonsuperconductive substrate having a helicoid continuous surface. However, also in this case, there is a problem in that the commercial production is very difficult as described above.

Accordingly, an object, which has been conceived in order to solve the above problems, is to provide a method of manufacturing a superconducting tape wire that can exhibit substantially the same effect as a long wire.

Figure 3 of US 6,153,825 shows a tape-like superconducting wire material on a cylindrical support member.

JP-63 -207007 shows a method of manufacturing a superconducting coil, which method includes: a step of forming an intermediate thin layer on a base; a step of forming a superconducting layer on the intermediate thin layer; and a machining step of forming at least one parting region extending from a one-end portion to an other-end portion in the superconducting layer, which extends from the one-end portion to the other-end portion. The parting region is a region which does not become superconductive at a critical temperature of the superconducting layer.

The invention is defined in the claims.

### Advantages

According to the method for manufacturing a superconducting tape wire of the present invention, the parting region is formed in the machining step. Hence, a wide superconducting tape wire can be processed into a plurality of relatively narrow superconducting tape wires which are disposed in parallel or into one superconducting tape wire arranged in series. If an apparatus such as a coil is formed using the superconducting tape wires disposed in parallel or the superconducting tape wire arranged in series as described above, the coil can be easily produced such that it has the number of turns equivalent to that of a coil formed by using a long tape wire which is made, for example, by connecting a plurality of the above-mentioned superconducting tape wires in series. That is, a superconducting tape wire having an effect similar to that of a long wire can easily be manufactured.

According to the superconducting tape wire produced according to the present invention, the parting region is provided. Hence, a wide superconducting tape wire can be formed such that it has the same effect as in the case where a plurality of wires are assembled in parallel arrangement.

In a superconducting apparatus, the parting region may be formed. Therefore, a superconducting apparatus having an effect similar to that of a superconducting apparatus using a long wire can be manufactured with a wide superconducting tape wire having a relatively short length. Consequently, the manufacturing cost can be reduced as compared with the case in which a long wire is used.

### Brief Description of the Drawings

Figure 1 is a schematic perspective view showing a superconducting tape wire according to Embodiment 1.
Figure 2 is a flowchart of a manufacturing method of the superconducting tape wire according to Embodiment 1.
Figure 3 is a schematic view showing a machining step according to Embodiment 1.
Figure 4 is a schematic perspective view showing a superconducting tape wire according to Embodiment 2.
Figure 5 is a flowchart of a manufacturing method of the superconducting tape wire according to Embodiment 2.
Figure 6 is a schematic perspective view showing a superconducting apparatus according to Embodiment 3.
Figure 7 is a flowchart of a manufacturing method of a superconducting coil according to Embodiment 3.
Figure 8 is a schematic view of a coil having one layer formed by using one superconducting tape wire.
Figure 9 is a schematic view illustrating a process of making a coil having three layers by using winding members formed from respective three superconducting tape wires.
Figure 10 is a flowchart showing a manufacturing method of a superconducting coil of a modified example according to Embodiment 3.
Figure 11 is a flowchart showing a manufacturing method of a superconducting coil according to Embodiment 4.
Figure 12 is a schematic perspective view showing a machining step according to Embodiment 4.
Figure 13 is a flowchart showing a manufacturing method of a superconducting coil according to Embodiment 5.
Figure 14A is a schematic top view showing a superconducting coil according to Embodiment 6.
Figure 14B is a schematic front view showing the superconducting coil according to Embodiment 6.

### Reference Numerals

10, 20, 30 superconducting tape wire; 11, 31 tape substrate; 13, 13b, 33, 33b, 53, 53b superconducting layer; 13a, 53a parting region; 13c, 32c one-end portion; 13d, 32d other-end portion; 13B region; 12, 32, 32b intermediate thin layer; 40, 60 superconducting coil; 32a intermediate-layer parting region; 33a superconducting-layer region; 41a boundary line; 41, 42, 43 winding member.

Hereinafter, embodiments will be described with reference to the figures, wherein the manufacturing method in Embodiment 1 illustrates the invention. In the figures, the same reference numerals designate the same or corresponding elements, and the description is not duplicated. The dimensional ratios shown in the figures do not always coincide with those described in the description of the present invention.

### (Embodiment 1)

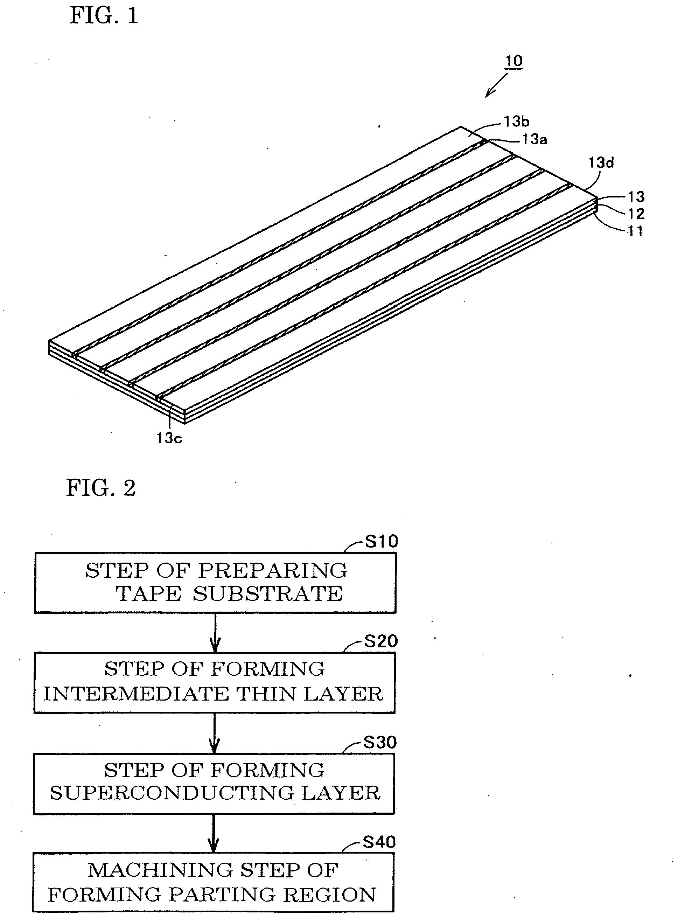

Figure 1 is a schematic perspective view showing a superconducting tape wire according to Embodiment 1. With reference to Fig. 1, the superconducting tape wire of Embodiment 1 will be described. A superconducting tape wire 10 according to Embodiment 1 includes a tape substrate 11, an intermediate thin layer 12, and a superconducting layer 13, as shown in Fig. 1.

The intermediate thin layer 12 is formed on the tape substrate 11. The superconducting layer 13 is formed on the intermediate thin layer 12 so as to extend from a one-end portion 13c to an other-end portion 13d, and includes at least one parting region 13a extending from the one-end portion 13c to the other-end portion 13d. The parting region 13a is a region which does not become superconductive at a critical temperature of a superconducting layer 13b.

In particular, one or plural parting regions 13a are formed in parallel in a longitudinal direction (direction from the one-end portion 13c to the other-end portion 13d in Fig. 1) of the superconducting layer 13. In Embodiment 1, the one-end portion 13c and the other-end portion 13d face each other.

The term "end portion" indicates the end. In Embodiment 1, as shown in Fig. 1, the one-end portion 13c and the other-end portion 13d both indicate the ends.

As apparent from a manufacturing method which will be described later, the parting region 13a is a portion which is made, by a process such as irradiating the superconducting layer 13 with laser light, to have the following state: a superconducting layer is not present as such at a part corresponding to the parting region 13a; or the provided material is not continuous in the depth direction to the tape substrate 11 (including a state in which a part or the whole of the intermediate thin layer under the parting region 13a is not present, or a state in which the intermediate thin layer and a part of the tape substrate, which are under the parting region 13a, are not present except for the case in which cutting is performed to the bottom surface of the tape substrate 11). That is, the parting region 13a is a portion in which the superconducting layer corresponding to the parting region 13a is not present; a portion in which the superconducting layer corresponding to the parting region 13a and the part of the intermediate thin layer 12 thereunder are not present (the other part of the intermediate thin layer 12 and the substrate 11 are present); a portion in which the superconducting layer corresponding to the parting region 13a and the whole of the intermediate thin layer 12 thereunder are not present (the substrate 11 is present); or a portion in which the superconducting layer corresponding to the parting region 13a, the whole of the intermediate thin layer 12 thereunder, and the part of the substrate 11 thereunder are not present (the other part of the substrate 11 is present).

In Embodiment 1, four rows of parting regions 13a are formed, and five rows of superconducting layers 13b are formed besides the parting regions 13a. Hence, the above structure is equivalent to that in which five superconducting tape wires (having the same width as that of the superconducting layer 13b in the direction perpendicular to the longitudinal direction) including no parting regions 13a are disposed in parallel. Therefore, the superconducting tape wire 10 has a width which allows such parting regions 13a to be formed. A plurality of parting regions 13a may be formed in parallel in a width direction (direction perpendicular to a longitudinal direction in Fig. 1, that is, direction parallel to the end faces of the one-end portion 13c and the other-end portion 13d).

The tape substrate 11 is formed using a textured tape made of Ni (nickel) or a Ni-based alloy. The intermediate thin layer 12 is formed using a material containing at least one of CeO₂ (Ceria) and YSZ (yttria stabilized zirconia). The superconducting layer 13 is formed using HoBCO (holmium-based high-temperature superconducting material: HoBa₂Cu₃Oₓ).

In addition, as a material for the tape substrate 11, besides the above Ni and Ni-based alloy, another material (such as another metal material or another flexible material) may also be used. The intermediate thin layer 12 is not limited to the above materials, and any material may also be used as long as the superconducting layer 13 can be formed thereon. Not limited to one layer structure, the intermediate thin layer 12 may be made of two or more layers. The superconducting layer 13 may be made of a rare earth-based superconducting material besides the above HoBCO, or a conventional metal-based superconducting material or other oxide-based superconducting material.

For the purpose of surface protection of the superconducting layer 13, a surface protection layer or a stabilizing layer (not shown), such as a Ag (silver) stabilizing layer or a Cu (copper) stabilizing layer, is provided on the superconducting layer 13. The surface protection layer on the parting region 13a may be similar to the state of the parting region 13a or the surface protection layer on the superconducting layer 13b, which is a portion other than the parting region 13a.

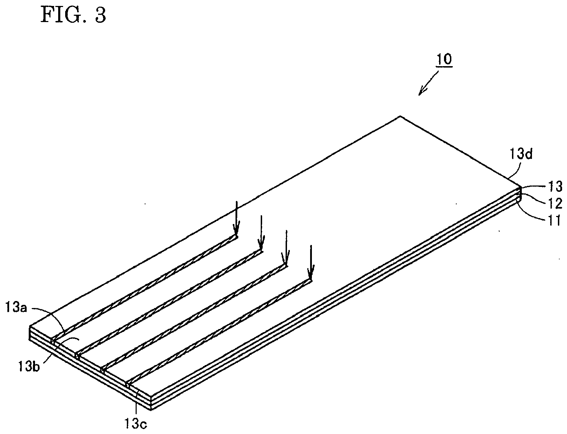

Next, with reference to Figs. 2 and 3, a method for manufacturing the superconducting tape wire 10 will be described. Figure 2 is a flowchart showing the manufacturing method of the superconducting tape material 10 of Embodiment 1. Figure 3 is a schematic view showing a machining step of Embodiment 1.

First, a step (S10) of preparing the tape substrate 11 is performed. In this step (S10), the above tape substrate 11 is prepared.

In this step (S20), the intermediate thin layer 12 is formed on the tape substrate 11, using the material described above by a physical vapor deposition method, an organometallic deposition method, or the like.

Next, a step (S30) of forming the superconducting layer 13 is performed. In this step (S30), the superconducting layer 13 is formed on the intermediate thin layer 12 by a method including at least one of an organometallic deposition method (MOD method) and a physical vapor deposition method, such as a PLD (Pulsed Laser Deposition) method or a sputtering method.

Next, a machining step (S40) of forming at least one parting region 13a extending from the one-end portion 13c to the other-end portion 13d is performed in the superconducting layer 13 which extends from the one-end portion 13c to the other-end portion 13d. In this step (S40), the parting region 13a is formed so as to be a region which does not become superconductive at the critical temperature of the superconducting layer 13b.

In Embodiment 1, the step (S40) is performed by lasers. In particular, as shown in Fig. 3, laser beams (arrows in Fig. 3) are irradiated in parallel (four lines in Fig. 3) in a longitudinal direction of the superconducting layer 13. Portions irradiated with laser beams become the parting regions 13a. The step (S40) may be performed in a manner such that the superconducting layer 13 is partly cut and removed or milling-cut at a part where the parting region 13a is to be formed (while the tape substrate 11 is not cut and is allowed to remain).

Finally, a step of forming the surface protection layer on the superconducting layer 13 is performed. In this step, after the parting regions 13a are formed, the surface protection layer is formed. In this case, the surface protection layer on the parting region 13a is similar to the surface protection layer on the superconducting layer 13b which is the portion other than the parting region 13a.

The step of forming a surface protection layer may be performed after the step (S30) of forming the superconducting layer 13 is performed. In this case, after the surface protection layer is formed, the machining step (S40) is performed. In this case, the state of the surface protection layer on the parting region 13a is similar to that of the parting region 13a.

Next, the function of the superconducting tape wire 10 of Embodiment 1 will be described. When a current is flowed in the superconducting tape wire 10 by applying a voltage between the one-end portion 13c and the other-end portion 13d, under predetermined conditions (for example, when the superconducting tape wire 10 is cooled to a temperature at which the superconducting layers 13b become superconductive), the current can be passed in a superconducting state through the superconducting layers 13b, which are the portions other than the parting regions 13a. At this stage, the state equivalent to a state in which superconducting wires are disposed in parallel is achieved since the superconducting layers 13b can be regarded as conductive wires electrically independent of each other.

The function of the superconducting tape wire 10 is not limited to that described above. For example, the superconducting layers 13b, which are portions other than the parting regions 13a, may be connected in series. In particular, adjacent superconducting layers 13b are electrically connected to each other at end portions thereof. In such case, since the superconducting layers 13b thus connected can be regarded as one conductive wire, the state equivalent to a state given by one long wire is achieved when a current is flowed.

As described above, the method for manufacturing the superconducting tape wire 10 according to Embodiment 1 includes the step (S10) of preparing the tape substrate 11, the step (S20) of forming the intermediate thin layer 12 on the tape substrate 11, the step (S30) of forming the superconducting layer 13 on the intermediate thin layer 12, and the step (S40) of forming, in the superconducting layer 13 extending from the one-end portion 13c to the other-end portion 13d, at least one parting region 13a which extends from the one-end portion 13c to the other-end portion 13d. The feature of the parting region 13a is that it does not become superconductive at the critical temperature of the superconducting layer 13b. Therefore, by forming such parting regions 13a, it is made possible to easily manufacture a superconducting tape wire 10 so that the superconducting tape wire 10 has an effect similar to that obtained by collecting the same number of superconducting tape wires as the number of regions of the superconducting layers 13b which are the portions other than the parting regions 13a. In addition, when a wide superconducting tape wire 10 is used, even if it is not a long one, the superconducting tape wire 10 can be formed such that it has an effect similar to that obtained by collecting the same number of superconducting tape wires (which have the same length as the superconducting tape wire 10) as the number of the regions of the superconducting tape wire 10, (that is, a structure can be manufactured which is equivalent to one in which superconducting tape wires are disposed in parallel, the total length of the tape wires being equal to (the length of the wide superconducting tape wire 10 in a longitudinal direction) × (the number of regions of the superconducting layers 13b)). Therefore, a structure which is equivalent to narrow superconducting tape wires disposed in parallel can be formed by dividing the wide superconducting tape wire 10, instead of using a long wire. According to the structure described above, when the number of divided portions is increased, the total length of the superconducting tape wire can be increased, and hence the superconducting tape wire 10, which can be used in a manner similar to that for a long superconducting tape wire, can be manufactured by mass production.

In the above method for manufacturing the superconducting tape wire 10, the machining step (S40) is preferably performed by laser beams. Accordingly, the parting region 13a can be easily formed. In addition, the width, position, and depth of the parting region 13a can easily be changed by changing the width, position, and depth of a region to be irradiated with a laser beam. Hence, the width and the number of the superconducting layers 13 which can be regarded as superconducting tape wires disposed in parallel can be easily changed.

In the above method for manufacturing the superconducting tape wire 10, the machining step (S40) is preferably performed to form one parting region 13a or a plurality of parting regions 13a disposed in parallel in the longitudinal direction of the superconducting layer 13. Accordingly, a plurality of current paths can be ensured with the superconducting layers 13b, which are portions other than the parting region 13a. Or, a wire equivalent to one long wire can be realized by connecting the superconducting layers 13 in series so that a current is passed therethrough. As a result, a high-quality superconducting tape wire 10 can be manufactured at reasonable cost, and hence mass production thereof can be performed.

In the above method for manufacturing the superconducting tape wire 10, the intermediate thin layer 12 is preferably formed by a physical vapor deposition method. The intermediate thin layer 12 having a superior film quality can be formed since a physical vapor deposition method, such as a PLD method or a sputtering method, that is capable of forming a superior film can be used.

In the above method for manufacturing the superconducting tape wire 10, the superconducting layer 13 is preferably formed by a method including at least one of a physical vapor deposition method and an organometallic deposition method. The physical vapor deposition method (such as a PLD method) is superior with respect to the properties of superconducting layers, and the MOD method is superior in terms of cost. Therefore, it will be possible to industrialize the manufacture of superconducting tape wires 10.

The superconducting tape wire 10 according to Embodiment 1 includes the tape substrate 11, the intermediate thin layer 12 formed thereon, and the superconducting layer 13 extending from the one-side portion 13c to the other-side portion 13d and having at least one parting region 13a extending from the one-side portion 13c to the other-side portion 13d, and the parting region 13a is characterized in that it does not become superconductive at the critical temperature of the superconducting layer 13b. Therefore, by forming the parting regions 13a, the superconducting tape wire 10 is made to have an effect similar to that of the superconducting tape wires that are collected by the same number as the number of the regions of the superconducting layers 13b which are portions other than the above parting regions 13a.

Also, when a wide superconducting tape wire 10 is used, even if it is not a long wire, it is possible to obtain an effect similar to that obtained by collecting the same number of superconducting tape wires (which have the same length as the superconducting tape wire 10) as the number of the regions of the superconducting tape wire 10. Therefore, it is not necessary for the superconducting tape wire 10 to be long. Accordingly, the industrialization of the superconducting tape wire 10 will become easier.

With respect to the above-described superconducting tape wire 10, preferably the tape substrate 11 is a textured metal tape made of Ni or a Ni alloy, the intermediate thin layer includes at least either of CeO₂ and yttria-stabilized zirconia, and the superconducting layer 13 includes HoBCO. This helps to obtain a structure in which the orientation of the tape substrate 11 is utilized. Accordingly, with the superconducting tape wire 10, it is possible to achieve such large critical current (Ic) and critical current density (Jc) as are required for practical application. Furthermore, the degree of freedom of selecting a material used for the tape substrate 11 can be increased. As a result, mass production of the superconducting tape wire 10 can be realized.

### (Embodiment 2)

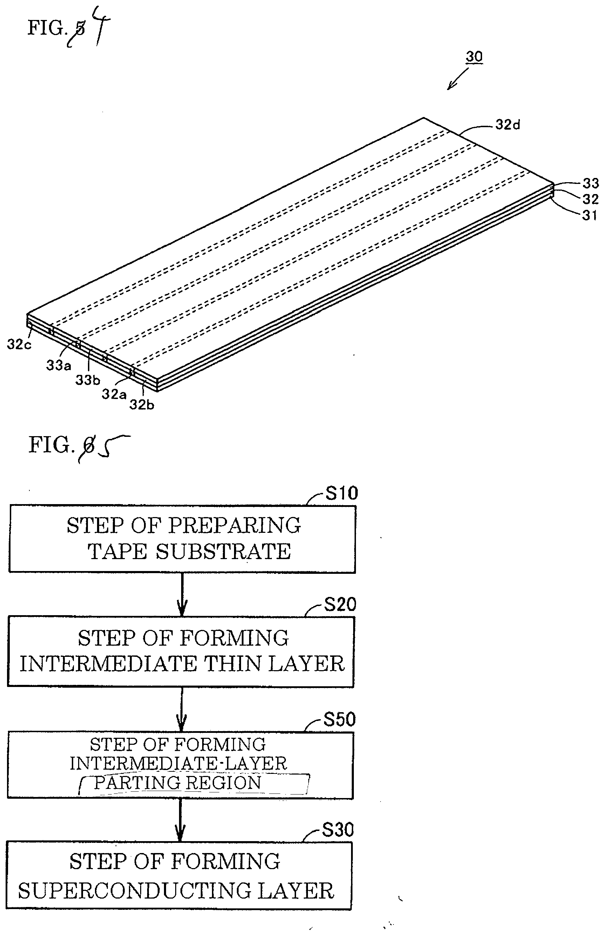

Figure 4 is a schematic perspective view showing a superconducting tape wire of Embodiment 2. With reference to Fig. 4, the superconducting tape wire according to Embodiment 2 of the present invention will be described. A superconducting tape wire 30 according to Embodiment 2 of the present invention includes a tape substrate 31, an intermediate thin layer 32, and a superconducting layer 33, as shown in Fig. 4.

The intermediate thin layer 32 is formed on the tape substrate 31 so as to extend from a one-end portion 32c to an other-end portion 32d and includes at least one intermediate-layer parting region 32a extending from the one-end portion 32c to the other-end portion 32d. The intermediate thin layer 32 includes at least one layer. The superconducting layer 33 is formed on the intermediate thin layer 32.

A superconducting-layer region 33a on the intermediate-layer parting region 32a is a region which is designed not to become superconductive at a critical temperature of a superconducting layer 33b. That is, the intermediate-layer parting region 32a is structured such that the superconducting-layer region 33a on the intermediate-layer parting region 32a does not become superconductive when the superconducting layer 33b on an intermediate thin layer 32b, which is a portion other than the intermediate-layer parting region 32a, becomes superconductive.

More specifically, a plurality of intermediate-layer parting regions 32a are formed in parallel in a longitudinal direction of the superconducting layer 33. In Embodiment 2, four intermediate-layer parting regions 32a are formed, and five intermediate thin layers 32b, which are portions other than the intermediate-layer parting regions 32a, are formed.

The superconducting-layer regions 33a on the intermediate-layer parting regions 32a are formed in parallel along a longitudinal direction thereof. In Embodiment 2, four superconducting-layer regions 33a are formed on the intermediate-layer parting regions 32a, and five superconducting layers 33b are formed on the regions other than the intermediate-layer parting regions 32a. Consequently, the superconducting tape wire 30 becomes equivalent to the case where five superconducting tape wires having the same length as the tape wire 30 and having no intermediate-layer parting regions 32a are arranged in parallel.

In Embodiment 2, the tape substrate 31, the intermediate thin layer 32, and the superconducting layer 33 are formed using materials similar to those of the tape substrate 11, the intermediate thin layer 12, and the superconducting layer 13, respectively, of Embodiment 1; however, as is the case of Embodiment 1, the structure is not limited thereto. Likewise, although not shown in the figure, the superconducting tape wire 30 is also provided with a surface protection layer, which is similar to Embodiment 1.

Next, with reference to Fig. 5, a method for manufacturing the superconducting tape wire 30 will be described. Figure 5 is a flowchart showing the manufacturing method of the superconducting tape wier 30 of Embodiment 2.

First, a step (S10) of preparing the tape substrate 31 is performed. Next, a step (S20) of forming the intermediate thin layer 32 on the tape substrate 31 is performed. The steps (S10, S20) are similar to the steps (S10, S20) of the manufacturing method of Embodiment 1, and hence the description is not duplicated.

Next, a machining step (S50) is performed such that at least one intermediate-layer parting region 32a extending from the one-end portion 32c to the other-end portion 32d is formed in the intermediate thin layer 32 which extends from the one-end portion 32c to the other-end portion 32d. The step (S50) is performed such that the superconducting-layer region 33a on the intermediate-layer parting region 32a becomes a region that will not attain a superconducting state at the critical temperature of the superconducting layer 33b.

In Embodiment 2, the step (S50) is performed by a laser as in the case of the step (S40) in Embodiment 1; however, it is not limited to the processing by the laser. An alternative method, such as a machining method described in the step (S40) of Embodiment 1, may optionally be used.

When the intermediate thin layer 32 is formed of two or more layers, the intermediate-layer parting region 32a may be formed in the topmost layer (layer formed at a position most apart from the tape substrate 31). The intermediate-layer parting region 32a may have any structure, provided that the superconducting-layer region 33a can be formed on the intermediate-layer parting region 32a in a manner such that the region 33a has inferior crystallinity (i.e., the crystalline structure is inferior in superconducting properties or exhibits no superconducting properties) as compared to the superconducting layer 33b formed on the intermediate thin layer 32b. For example, the quality of the upper surface (surface at the superconducting layer 33 side) of the intermediate-layer parting region 32a may be different from the quality of the upper surface of the intermediate thin layer 32b. In the case where the intermediate thin layer 32 is formed of a plurality of layers, the intermediate-layer parting region 32a may be formed in the topmost layer that contacts with the superconducting layer 33, or may be formed on the surface, which lies on the superconducting layer 33 side, of the topmost layer, or may be formed so as to penetrate the above plurality of layers.

Next, a step (S30) of forming the superconducting layer 33 on the intermediate thin layer 32 is performed. When this step (S30) is performed, the crystallinity of the superconducting-layer region 33a on the intermediate-layer parting region 32a is different from that of the superconducting layer 33b on the intermediate thin layer 32b which is a portion other than the intermediate-layer parting region 32a.

Next, a step of forming the surface protection layer is performed. By the above steps (S10, S20, S50, and S30), the superconducting tape wire 30 of Embodiment 2 can be manufactured.

Since the function of the superconducting tape wire 30 is similar to that of the superconducting tape wire 10 of Embodiment 1, the description is not duplicated.

As described above, the method for manufacturing the superconducting tape wire 30 of Embodiment 2 according to the present invention includes: the step (S10) of preparing the tape substrate 31; the step (S20) of forming the intermediate thin layer 32 on the tape substrate 31; the machining step (S50) of forming at least one intermediate-layer parting region 32a extending from a one-end portion to an other-end portion in the intermediate thin layer 32, which extends from the one-end portion to the other-end portion; and the step (S30) of forming the superconducting layer 33 on the intermediate thin layer 32, such that the superconducting-layer region 33a on the intermediate-layer parting region 32a is a region which does not come to a superconducting state at the critical temperature of the superconducting layer 33b. By forming the intermediate-layer parting regions 32a in the superconducting tape wire 30, the superconducting tape wire 30 can easily be produced such that one superconducting tape wire has an effect similar to that obtained by the same number of collected superconducting wires (disposed in series) as the number of the regions of the superconducting layers 33b provided on the intermediate thin layers 32b which are the regions other than the intermediate-layer parting regions 32a. Therefore, it is possible to use such wide superconducting tape wire 30 instead of a long wire, and hence the industrialization of the superconducting tape wire 30 will become possible.

The superconducting tape wire 30 according to Embodiment 2 of the present invention includes: the tape substrate 31; the intermediate thin layer 32 formed extending from the one-end portion to the other-end portion on the tape substrate 31 and having at least one intermediate-layer parting region 32a extending from the one-end portion to the other-end portion; and the superconducting layer 33 formed on the intermediate thin layer 32, whereas the superconducting layer 33a formed on the intermediate-layer parting region 32a is a region which does not become superconductive at the critical temperature of the superconducting layer 33b. By forming the intermediate-layer parting region 32a, the superconducting tape wire 30 is made such that one tape wire has an effect similar to that of superconducting tape wires collected by the same number as the number of the regions of the superconducting layers 33b formed on the intermediate thin layers 32b defined by the intermediate-layer parting regions 32a.

### (Embodiment 3)

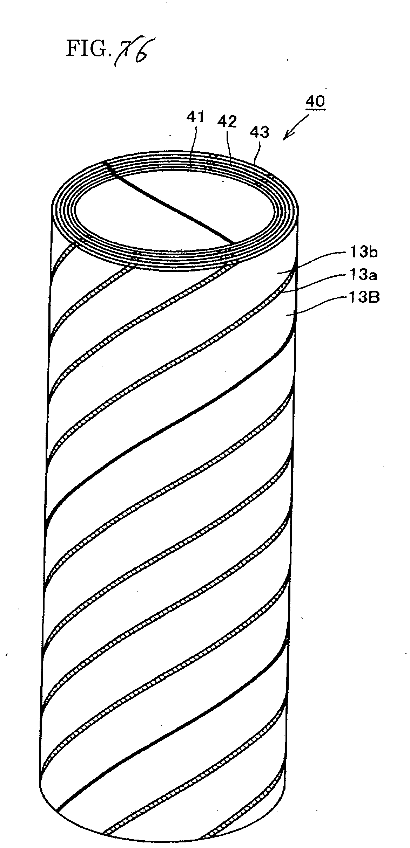

Figure 6 is a schematic perspective view showing a superconducting apparatus according to Embodiment 3. With reference to Fig. 6, the superconducting apparatus according to Embodiment 3 will be described. The superconducting apparatus according to Embodiment 3 is a superconducting coil. The superconducting coil 40 of Embodiment 3 is formed using superconducting tape wires 10 of Embodiment 1.

As shown in Fig. 6, the superconducting coil 40 is composed of winding members 41, 42, and 43 which are each formed by winding a superconducting tape wire 10 (see Fig. 1) including a tape substrate 11 and a superconducting layer 13 in which parting regions 13a are formed such that the parting regions 13a are structured so as not to become superconductive when the superconducting layers 13b, which are the portions other than the parting regions 13a, come to a superconducting state.

The above-mentioned "winding member" is a tubular or solid columnar body, and the cross-section thereof may be a shape optionally selected, such as a round, a polygonal, or a partly recessed shape.

In Embodiment 3, the superconducting coil 40 has the winding members 41 to 43 formed of three superconducting tape wires 10. The superconducting tape wires 10 are spirally wound, so that the winding members 41 to 43 each having a cylindrical shape are formed. The winding members 41, 42, and 43 are disposed in the enumerated order from the inner side of the superconducting coil 40 such that the winding member 43 made of the superconducting tape wire 10 is disposed as the outermost layer, and thereby a three-layer coil is formed. The inner one of the winding members 41 to 43 arranged in the superconducting coil 40 has a smaller outer diameter than the other one arranged at the outer side.

The superconducting tape wires 10, each including the tape substrate 11 and the superconducting layer 13 in which the parting regions 13a are formed, are respectively wound in a cylindrical form such that the two or more regions defined by the parting regions 13a are arranged in a spiral manner. Accordingly, the winding members 41 to 43 are formed.

In Embodiment 3, as shown in Fig. 6, an attention should be paid particularly to a region 13B optionally selected among five regions of superconducting layers 13b, which are formed as defined by four parting regions 13a in the outermost winding member 43 made of the superconducting tape wire 10. The optional region 13B of the winding member 43 is connected by soldering or the like to the region of the winding member 42, which region corresponds to the region 13B. Likewise, the region corresponding to the region 13B of the winding member 42 is connected by soldering or the like to the region corresponding to the region 13B of the winding member 41. As described above, the individual corresponding regions of the winding members 41 to 43 are connected to each other.

The structure of the coil is not limited to that described above, and it may consist of one layer (may be formed of one winding member). The parting region 13a may be divided so as to form as many regions as possible, if the number is more than two. Also, each of the winding members 41 to 43 constituting the coil may be formed using two or more (e.g., three) superconducting tape wires 10 in combination, instead of using only one superconducting tape wire 10. For example, after the one-end portions 13c of the three superconducting tape wires 10 are each subjected to a predetermined process (e.g., process of obliquely cutting the end portion for performing spiral winding, or the like), the edges of the end portions thus processed are connected to each other, so that a circular opening portion at the end portion of a winding member is formed. Subsequently, while the three superconducting tape wires are spirally wound, they are connected to each other to form one coil (that is, the outer peripheral side surface of one coil is formed of plural (e.g., three) superconducting tape wires 10). Accordingly, a coil having a large diameter can be formed using a plurality of the superconducting tape wires 10.

In the superconducting coil 40, a surface protection layer is provided on the superconducting layer 13, although it is not shown in the figure.

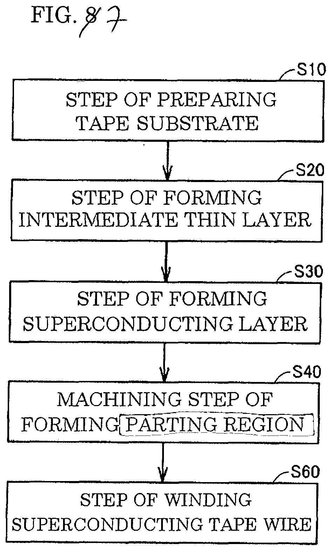

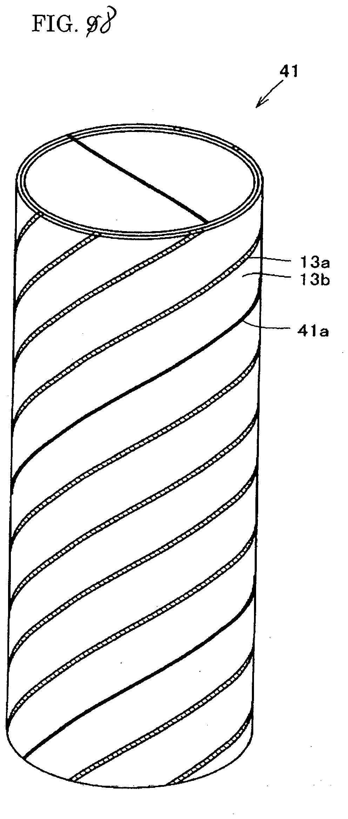

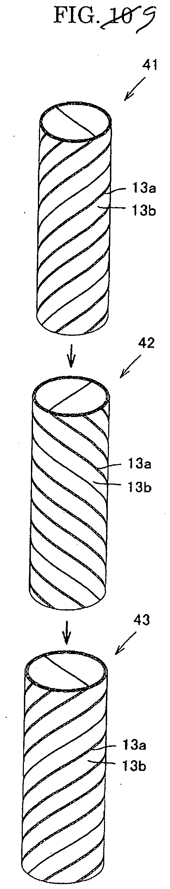

Next, with reference to Figs. 7 to 9, a method for manufacturing the superconducting coil 40 will be described. Figure 7 is a flowchart showing a method for manufacturing the superconducting coil 40 of Embodiment 3. Figure 8 is a schematic view showing a one-layer coil manufactured by using one superconducting tape wire 10. Figure 9 is a schematic view illustrating a process of making a three-layered coil by using winding members 41 to 43 formed from respective three superconducting tape wires.

First, a step of forming a superconducting coil that is the innermost winding member 41 is performed by the manufacturing method of the superconducting tape wire 10. In Embodiment 3, the superconducting coil is formed using the superconducting tape wire 10 of Embodiment 1. Therefore, in particular as shown in Fig. 7, a step (S10) of preparing the tape substrate 11 is first performed. Next, a step (S20) of forming the intermediate thin layer on the tape substrate 11 is performed. Subsequently, a step (S30) of forming the superconducting layer 13 is performed. Then, a machining step (S40) is performed in which at least one parting region 13a extending from a one-end portion 13c to an other-end portion 13d is formed in the superconducting layer 13 extending from the one-end portion 13c to the other-end portion 13d. Since the steps (S10 to S40) are similar to those of Embodiment 1, the description is not duplicated.

Next, a step (S60) of winding the superconducting tape wire 10 is performed. In this step (S60), the winding member 41 is formed.

In Embodiment 3, as shown in Fig. 8, the superconducting tape wire 10 provided with the parting regions 13a is wound in a cylindrical shape so that at least two regions defined by the parting regions 13a each form a spiral shape. In this step, the superconducting tape wire 10 is spirally wound such that neither overlaps nor gaps are generated at a boundary line 41a corresponding to a longitudinal edge of the superconducting tape wire 10.

Subsequently, as shown in Fig. 9, the step (S60) is performed for three superconducting tape wires 10, so that the winding members 41, 42, and 43 are formed. Next, as shown in Fig. 9, the winding members 41, 42, and 43 are sequentially disposed in an overlapping manner in the enumerated order (they are disposed concentrically, or the winding member 42 is disposed so as to cover the outer periphery of the winding member 41 and the winding member 43 is disposed so as to cover the outer periphery of the winding member 42). The cylindrical inner diameters of the winding members 41, 42, and 43 are increased in order so that they can be disposed in the overlapping manner.

By performing the steps (S10 to S60), the superconducting coil 40 of Embodiment 3 can be manufactured. Subsequently, the corresponding regions (superconducting layers 13b) of the winding members 41 to 43 are electrically connected to each other as described above.

Next, with reference to Fig. 6, the function of the superconducting coil 40 will be described. In order to pass current through the superconducting coil 40, it is connected to an electrical source. In the superconducting coil 40, the connection of the winding members 41, 42, and 43 is made such that the respective regions defined by the formation of the parting regions 13a are connected to each other. In the winding members 41, 42, and 43 thus connected via the respective regions, the ends of the connection are connected to electrical sources.

In Embodiment 3, an end portion (for example, at a lower end in Fig. 6) of an optionally selected region 13B of the five superconducting layers 13b defined by the formation of the four parting regions 13a in the winding member 43 is connected to one end portion (for example, at a lower end in Fig. 6) of a region 13B of the winding member 42. Likewise, the other end portion (for example, at an upper end in Fig. 6) of the region 13B of the winding member 42 is connected to one end portion (for example, at an upper end in Fig. 6) of a region 13B of the winding member 41. Accordingly, the winding members are electrically connected to each other.

Thus, when the electrical source is turned on, in the superconducting coil 40 formed by the connection described above, current passes through the region 13B (for example, in the upper direction in Fig. 6) of the winding member 41, the region 13B (for example, in the lower direction in Fig. 6) of the winding member 42, and the region 13B (for example, in the upper direction in Fig. 6) of the winding member 43. In such manner, current can be passed through each of the five regions, and a superconducting state can be realized under predetermined conditions.

The structure is not particularly limited to that described above. For example, in the respective superconducting tape wire 10 of the winding members 41, 42, and 43, the end portions of the five superconducting layers 13b, which are the portions other than the parting regions 13a, may be connected together such that adjacent superconducting layers 13b are connected in series. Subsequently, the winding members 41, 42, and 43 are connected to each other. Then, they can be regarded as one conductive wire. That is, they become equivalent to one long wire. Thus, when an electrical source is connected to the end of the superconducting layers and winding members thus connected, only one electrical source is necessary. Accordingly, the number of electrical sources can be decreased, and hence an inexpensive superconducting coil can be manufactured. When current is passed through this superconducting coil, under predetermined conditions, a superconducting state can be realized in one flow path.

As has thus been described, the superconducting coil 40, which is one example of the superconducting apparatus according to Embodiment 3, is a superconducting apparatus using the superconducting tape wires 10 of Embodiment 1. Therefore, by forming the parting regions 13a, one superconducting tape wire 10 can be processed into a superconducting tape wire having an effect similar to that obtained by collecting superconducting wires by the same number as the number of the regions constituting the superconducting layers 13b which are the portions other than the parting regions 13a; hence, the superconducting coil 40 can be easily manufactured using the above superconducting tape wires.

The method for manufacturing the superconducting coil 40, which is one example of the superconducting apparatus according to Embodiment 3, includes the steps (S10 to S40) of manufacturing superconducting tape wires 10 in accordance with the manufacturing method of the superconducting tape wire 10 in Embodiment 1, and the step (S60) of winding the superconducting tape wires 10. Hence, the superconducting coil 40 can easily be manufactured using the superconducting tape wires 10 each of which, as a result of formation of the parting regions 13a, has an effect similar to that obtained by collecting superconducting wires by the same number as the number of the regions constituting the superconducting layers 13b which are the portions other than the parting regions 13a. Accordingly, since the wide superconducting tape wire 10 can be used without using a long wire, mass production of the superconducting coil 40 can be realized.

Next, a modified example of the superconducting coil 40 of Embodiment 3 will be described. The structure of a superconducting coil, which is one example of a superconducting apparatus of the modified example, is basically similar to that of the superconducting coil 40 according to Embodiment 3; however, intermediate-layer parting regions are formed in the intermediate thin layer, and this is a different point from the superconducting coil 40 shown in Fig. 6.

In particular, the superconducting tape wire 30 of Embodiment 2 is used. As shown in Fig. 4, in particular, the superconducting tape wire 30 has the tape substrate 31, the intermediate thin layer 32, and the superconducting layer 33. The superconducting coil of the modified example is formed of winding members each of which is made in a cylindrical shape by winding the superconducting tape wire 30, in which the intermediate-layer parting regions 32a are formed such that two or more regions defined by the superconducting layers 33a on the intermediate-layer parting regions 32a form a spiral shape.

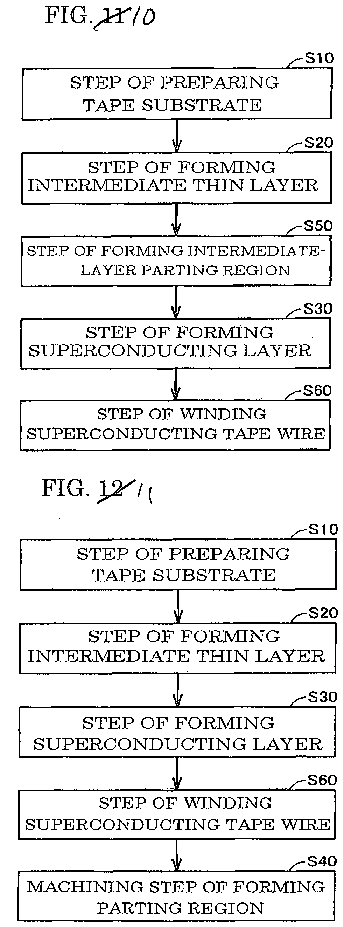

Next, with reference to Fig. 10, a method for manufacturing the superconducting coil of the modified example of Embodiment 3 will be described. Figure 10 is a flowchart showing the manufacturing method of the superconducting coil of the modified example.

The structure of the manufacturing method of the superconducting coil of the modified example of Embodiment 3 is basically similar to that of the manufacturing method of the superconducting coil 40 according to Embodiment 3 except that the superconducting tape wire of Embodiment 2 is used for the manufacturing, and this is the point different from the manufacturing method of the superconducting coil 40 shown in Fig. 7.

First, a step of manufacturing the superconducting tape wire 30 is performed by the manufacturing method of the superconducting tape wire 30 of Embodiment 2. In particular, as shown in Fig. 10, a step (S10) of preparing the tape substrate 31 is performed. Next, a step (S20) of forming the intermediate thin layer 32 on the tape substrate 31 is performed. Next, a machining step (S50) is performed such that at least one intermediate-layer parting region 32a is formed extending from a one-end portion to an other-end portion in the intermediate thin layer 32, which extends from the one-end portion to the other-end portion. Subsequently, a step (S30) of forming the superconducting layer 33 on the intermediate thin layer 32 is performed. The steps (S10, S20, S50, and S30) are similar to the steps (S10, S20, S50, and S30) of the manufacturing method in Embodiment 2, and hence the description is not duplicated.

Next, a step (S60) of winding the superconducting tape wire 30 is performed. Since this step (S60) is similar to the step (S60) of the manufacturing method of Embodiment 3, the description is not duplicated.

The winding members 41 to 43 are formed by performing the steps (S10, S20, S50, S30, and S60) and are then assembled together, so that the superconducting coil of the modified example of Embodiment 3 can be manufactured.

As has thus been described, according to the superconducting coil, which is one example of the superconducting apparatus of the modified example of Embodiment 3, the superconducting tape wire 30 of Embodiment 2 is used. Accordingly, the superconducting coil is obtained which includes the intermediate thin layers 32 having the intermediate-layer parting regions 32a.

As described above, the manufacturing method of the superconducting coil, which is one example of the superconducting apparatus of the modified example of Embodiment 3, has the steps (S10, S20, S50, and S30) of manufacturing the superconducting tape wires 30 by the manufacturing method of the superconducting tape wire 30 of Embodiment 3, and the step (S60) of winding the superconducting tape wires 30 formed by the manufacturing steps (S10, S20, S50, and S30). Hence, the superconducting coil can be easily manufactured which includes the intermediate thin layers 32 having the intermediate-layer parting regions 32a.

### (Embodiment 4)

Embodiment 4 is a superconducting coil which is one example of a superconducting apparatus. The structure of the superconducting coil according to Embodiment 4 is basically similar to that of the superconducting coil 40 of Embodiment 3 shown in Fig. 6 except for the manufacturing method. Hence, as for the superconducting coil of Embodiment 4, the description is not duplicated.

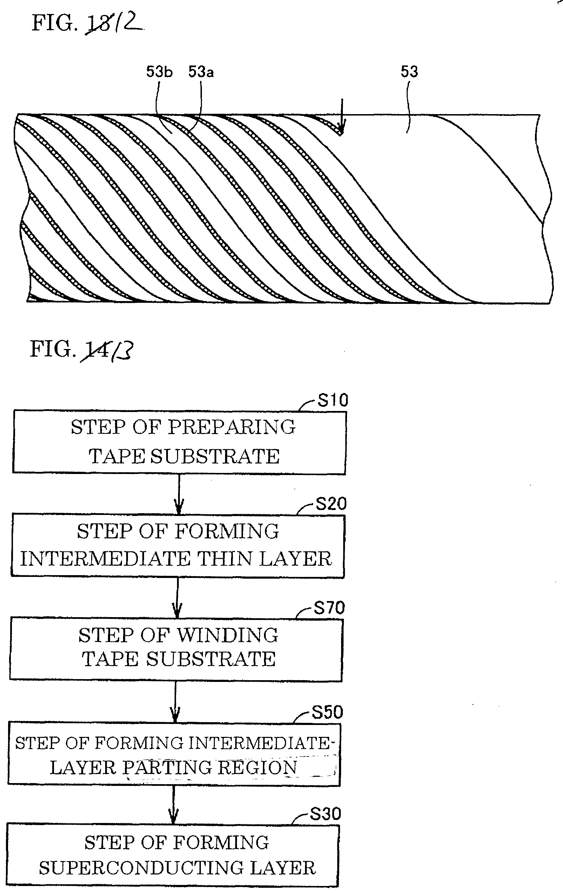

Next, with reference to Figs. 11 and 12, a method for manufacturing the superconducting coil according to Embodiment 4 will be described. Figure 11 is a flowchart showing the manufacturing method of the superconducting coil according to Embodiment 4. Figure 12 is a schematic perspective view showing a machining step of Embodiment 4.

First, a step (S10) of preparing a tape substrate is performed. Next, a step (S20) of forming an intermediate thin layer on the tape substrate is performed. Subsequently, a step (S30) of forming the superconducting layer 33 on the intermediate thin layer 32 is performed. Since the steps (S10 to S30) are similar to the steps (S10 to S30) of the manufacturing method of Embodiment 1, the description is not duplicated.

Next, a step (S60) of winding a superconducting tape wire is performed. Since this step (S60) is similar to the step (S60) of the manufacturing method of Embodiment 3, the description is not duplicated.

Next, in a superconducting layer of a wound superconducting tape wire, a machining step (S40) is performed such that at least one parting region is formed extending from a one-end portion located at an end to an other-end portion located at the other end, thereby the superconducting layer being divided into at least two regions extending from the one-end portion to the other-end portion. This step (S40) is performed so that the parting region may become a region which does not come to a superconducting state at a critical temperature of the superconducting layer.

In the step (S40) of Embodiment 4, for example, two ends of the winding member formed by the step (S60) are fixed. For the fixing, fixing members may be used. By using the fixing members, the shape of the superconducting coil can be easily maintained. The step (S40) is not particularly limited to that described above, provided that the parting region can be formed in the winding member. For example, as long as the wound superconducting tape wire is maintained in the wound state, the parting region can be formed.

Subsequently, as shown in Fig. 12, for example, parting regions 53a are formed by irradiating a superconducting layer 53 of the superconducting tape wire with laser beams. In particular, the superconducting layer 53 of the winding member is spirally irradiated with laser beams, so that the parting regions 53a are formed. In Embodiment 4, four parting regions 53a are formed in parallel. Accordingly, a winding member having a cylindrical shape can be formed in which five regions of superconducting layers 53b defined by the parting regions 53a each form a spiral shape.

The winding members can be manufactured by the above steps (S10, S20, S30, S60, and S40), and by combining the winding members together, the superconducting coil of Embodiment 4 can be produced.

Since the function of the superconducting coil of Embodiment 4 is similar to that of the superconducting coil of Embodiment 3, the description is not duplicated.

As has thus been described, the manufacturing method of the superconducting coil, which is one example of the superconducting apparatus of Embodiment 4, includes the step (S10) of preparing the tape substrate, the step (S20) of forming the intermediate thin layer on the tape substrate, the step (S30) of forming the superconducting layer 53 on the intermediate thin layer 32, the step (S60) of winding the superconducting tape wire, and the machining step (S40) in which one or more parting regions 53a are formed extending from a one-end portion located at one end to the other-end portion located at the other end in the superconducting layer 53 of the wound superconducting tape wire, thereby the superconducting layer 53 being divided into two or more regions extending from the one-end portion to the other-end portion, whereas the machining step (S40) includes a step in which the portions to be formed into the parting regions 53a of the superconducting layer 53 are processed so as not to become superconductive when the superconducting layers 53b, which are the portions other than the parting regions, come to a superconducting state. Accordingly, after the superconducting tape wire is formed into the winding member, the machining step (S40) can be performed. Thus, a superconducting coil can easily be manufactured using a superconducting tape wire which has, as a result of formation of the parting regions 53a, an effect similar to that obtained by the superconducting tape wires collected by the same number as the number of the regions constituting the superconducting layers 53b which are the portions other than the parting regions 53a. Therefore, the industrial production of the superconducting coil will be possible.

### (Embodiment 5)

Embodiment 5 is a superconducting coil which is one example of a superconducting apparatus. The structure of the superconducting coil according to Embodiment 5 is basically similar to that of the superconducting coil of Embodiment 3 shown in Fig. 6 except that the manufacturing method thereof is different from that of Embodiment 3.

The superconducting coil of Embodiment 5 has a tape substrate, an intermediate thin layer, and a superconducting layer. The intermediate thin layer is formed extending from a one-end portion to an other-end portion on the tape substrate and includes at least one intermediate-layer parting region which extends from the one-end portion to the other-end portion. The superconducting layer is formed on the intermediate thin layer. A winding member is formed by winding a superconducting tape wire which includes the tape substrate, the intermediate thin layer having an intermediate-layer parting region, and the superconducting layer. A superconducting-layer region on the intermediate-layer parting region is a region which does not become superconductive at a critical temperature of the superconducting layer.

Thus, the winding member having a cylindrical shape is structured by winding the superconducting tape wire including the tape substrate, the superconducting layer, and the intermediate thin layer in which an intermediate-layer parting region is formed such that at least two regions defined thereby each form a spiral shape.

Next, the manufacturing method of the superconducting coil according to Embodiment 5 will be described. Figure 13 is a flowchart showing the manufacturing method of the superconducting coil according to Embodiment 5.

As shown in Fig. 13, first, a step (S10) of preparing the tape substrate is performed. Next, a step (S20) of forming the intermediate thin layer on the tape substrate is performed. Since the steps (S10 and S20) are similar to the steps (S10 and S20) of the manufacturing method of Embodiment 2, the description is not duplicated.

Next, a step (S70) of winding a tape-like member is performed. In this step (S70), the tape-like member including the tape substrate and the intermediate thin layer is wound in a spiral form so as to be formed into a cylindrical shape.

Next, in the intermediate thin layer of the wound tape-like member, the machining step (S50) of forming at least one intermediate-layer parting region extending from a one-end portion located at one end to the other-end portion located at the other end is performed so that the intermediate thin layer may have at least two regions which extend from the one-end portion to the other-end portion. In this step (S50), which is basically similar to the step (S50) of Embodiment 4, the intermediate-layer parting region is formed in the intermediate thin layer of the tape-like member which has been formed into a winding member. In particular, as in the case of the step (S40) of Embodiment 4, the both ends of the winding member are fixed, and the intermediate-layer parting regions are formed in the intermediate thin layer by irradiation of laser beams.

Subsequently, a step (S30) of forming the superconducting layer on the intermediate thin layer is performed. In this step (S30), a method similar to that of the step (S30) of the manufacturing method of Embodiment 2 can be used. Then, a superconducting coil is produced by combining a plurality of winding members including the superconducting layers thus formed.

By performing the above steps (S10, S20, S70, S50, and S30), the superconducting coil of Embodiment 5 can be manufactured.

Since the function of the superconducting coil of Embodiment 5 is similar to that of the superconducting coil 40 of Embodiment 3, the description is not duplicated.

As has thus been described, the manufacturing method of the superconducting coil, which is one example of the superconducting apparatus of Embodiment 5, includes the step (S10) of preparing the tape substrate, the step (S20) of forming the intermediate thin layer on the tape substrate, the step (S70) of winding the tape-like member, the machining step (S50) in which at least one intermediate-layer parting region is formed extending from a one-end portion located at an end portion to the other-end portion located at the other end in the intermediate thin layer of the wound tape-like member so that the intermediate thin layer may be divided into at least two regions extending from the one-end portion to the other-end portion, and the step (S30) of forming the superconducting layer on the intermediate thin layer, whereas the superconducting-layer region on the intermediate-layer parting region is a region which does not become superconductive at the critical temperature of the superconducting layer. Accordingly, after the tape substrate is formed into the winding member, the machining step (S50) can be performed. Therefore, it is possible to easily form a superconducting coil including a superconducting tape wire which, as a result of formation of such intermediate-layer parting regions, has an effect similar to that obtained by collecting superconducting tape wires by the same number as the number of the superconducting layer regions which are the portions other than the intermediate-layer parting regions. As a result, mass production of the superconducting coil can be realized.

### (Embodiment 6)

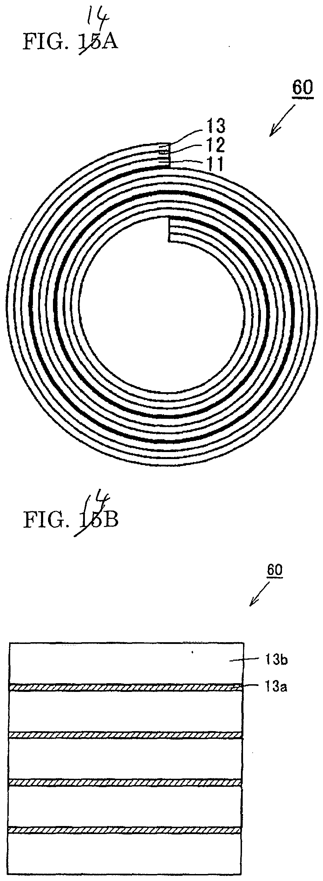

Figure 14A is a schematic top view showing a superconducting coil of Embodiment 6, and Fig. 14B is a schematic front view showing the superconducting coil of Embodiment 6. With reference to Figs. 14A and 14B, a superconducting apparatus according to Embodiment 6 will be described. The superconducting apparatus according to Embodiment 6 is a superconducting coil. A superconducting coil 60 of Embodiment 6 is a winding member formed by using the superconducting tape wire 10 of Embodiment 1.

In particular, as shown in Figs. 14A and 14B, the superconducting coil 60 includes the tape substrate 11, the intermediate thin layer 12, and the superconducting layer 13. The superconducting layer 13 includes four parting regions 13a formed in parallel so as to divide the superconducting layer 13 into five superconducting layer regions 13b.

Thus, a winding member is formed in a manner such that the superconducting tape wire 10, which includes the tape substrate 11 and the superconducting layer 13 having the parting regions 13a, is wound in a cylindrical form, with an axis of one side in a width direction of the superconducting tape wire 10, around the hollow generated in the center by winding. In Figs. 14A and 14B, the superconducting coil is formed from one winding member.

Next, a method for manufacturing the superconducting coil of Embodiment 6 will be described. The manufacturing method of the superconducting coil includes the steps (S10 to S40) of manufacturing the superconducting tape wire 10 of Embodiment 1 and the step (S60) of winding the superconducting tape wire of Embodiment 3.

In particular, first, the steps (S10 to S40) of manufacturing the superconducting tape wire 10 of Embodiment 1 are performed.

Next, the winding step (S60) is performed. In this step (S60), the superconducting tape wire 10 having the parting regions 13a formed therein is wound in a cylindrical shape so that at least two regions defined by the parting regions 13a each form a spiral shape. In Embodiment 6, the superconducting tape wire 10 is wound into a cylindrical shape in a manner such that the parting regions 13a each are caused to form a spiral shape by spirally winding the superconducting tape wire 10.

By performing the steps (S10, S20, S30, S40, and S60), the superconducting coil of Embodiment 6 can be manufactured.

The function of the superconducting coil of Embodiment 6 is similar to that of the superconducting coil 40 of Embodiment 3, and hence the description is not duplicated.

As described above, according to the manufacturing method of the superconducting coil, which is one example of the superconducting apparatus of Embodiment 6, the spiral winding method is used in the winding step (S60). Hence, a coil having a desired shape can be easily manufactured.

In addition, in the case of a superconducting coil, which is one example of the superconducting apparatus of Embodiment 6, the coil can be formed in a desired shape, since the structure is such that the coil can be formed by winding the winding member in convolution.

In Embodiments 3 to 6 described above, superconducting coils are described as examples of the superconducting apparatus; however, the superconducting apparatus is not limited to a coil. For example, a superconducting cable or a power storage system may also be mentioned as the superconducting apparatus. Also, the cross-section of the superconducting coils and the winding members described by way of example was a circular shape. However, the cross-sectional shape is not limited to a circular shape, and for example, other shapes (such as polygons including a triangle and a quadrangle or a shape containing a curve part and a linear part in combination) may also be mentioned.

### Reference Example 1

In Reference Example 1 and Comparative Examples 1 and 2 described below, superconducting coils shown in the top column of Table 1 were formed using superconducting tape wires shown in the bottom column of Table 1. The superconducting coils of Reference Example 1 and Comparative Examples 1 and 2 were formed to be used as an NMR coil at a frequency of 1GHz.

### (Formation of Superconducting Coil in Reference Example 1)

In Reference Example 1, the superconducting coil was formed in accordance with the manufacturing method described in Embodiment 1. In particular, first, the step (S10) of preparing the tape substrate was performed. A Ni-W (tungsten) textured metal tape, which was a Ni alloy-based textured tape, was used as the tape substrate. Next, the step (S20) of forming the intermediate thin layer on the tape substrate was performed. In this step (S20), a three-layer intermediate layer (CeO₂/YSZ/CeO₂) was formed as the intermediate thin layer in a manner such that a CeO₂ layer was formed on the tape substrate by an RF sputtering method and a YSZ layer was formed thereon by a PLD method. Next, the step (S30) of forming the superconducting layer on the intermediate thin layer was performed. In this step (S30), the superconducting layer was formed such that a HoBCO film having a thickness of approximately 1.0 µm was epitaxially grown on the intermediate thin layer by a PLD method.

In this superconducting tape wire, when Jc (critical current density) was assumed to be 1 MA/cm² (77K, 0 T) at a film thickness of 1 µm, Ic (77K, 0 T) = 100 A was satisfied, and it corresponds to Ic (4.2K, 25 T)= 1,000 A under magnetic field conditions in which the temperature was 4.2K and the magnetic flux density was 25 T, which were the conditions for an NMR coil at a frequency of 1 GHz.

A superconducting tape wire made by forming a silver film having a thickness of 5 µm and a copper plating having a thickness of 20 µm on the superconducting layer were of a large width dimension, having a thickness of 0.1 mm and a width of 5 cm.

In this step (S40), by sequential irradiation of YAG laser, four parting regions were formed in parallel in a longitudinal direction of the superconducting layer so as to divide the superconducting layer into five regions each having a width of 1 cm.

Subsequently, a winding step (S60) was performed. In this step (S60), the superconducting tape wire was wound in a cylindrical shape so that five regions defined by the parting regions each form a spiral shape. When 20 layers are laminated and connected to each other, an NMR coil at a frequency of 1 GHz was obtained. Accordingly, the superconducting coil of Reference Example 1 was formed.

### (Formation of Superconducting Coil in Comparative Example 1)

In Comparative Example 1, using a Bi-2212 round wire having a diameter of 2.0 mm, a superconducting coil including 14 layers was formed. In this case, Bi-2212 indicated a Bi-Sr-Ca-Cu-O-based superconducting oxide in which bismuth, lead, strontium, calcium, copper, and oxygen were contained, and in which the atomic ratios (excluding oxygen) of (bismuth + lead), strontium, calcium, and copper were represented by approximately 2, 2, 1, and 2, respectively (Bi-2212 was represented by (Bi, Pb)2212 in some cases). In more particular, a compound represented by a chemical formula of (BiPb)₂Sr₂Ca₁Cu₂O_{8+Z} was contained.

In the chemical formula, z indicates the content of oxygen, and it is known that the critical temperature (Tc) and the critical current (Ic) change depending on the change of z.

### (Formation of Superconducting Coil in Comparative Example 2)

In Comparative Example 2, steps similar to the steps (S10 to S30) of the manufacturing method of Example 1 were performed except that a superconducting tape wire having a width of 1 cm was used.

Next, without performing the machining step (S40), the winding step (S60) was performed. Accordingly, a superconducting coil including 20 layers was formed in Comparative Example 2.

**[Table 1]**

| | Reference Example 1 | Comparative Example 1 | Comparative Example 2 |
|---|---|---|---|
| Coil | | | |
| Inner diameter (mm) | 75 | 75 | 75 |
| Outer diameter (mm) | 126 | 126 | 126 |
| Length (mm) | 600 | 600 | 600 |
| Number of Turns | 1,260 | 4,095 | 1,260 |
| Number of Layers | 20 | 14 | 20 |
| Current (A) | 160 × 5 lines Series Connection | 300 | 1,000 |
| Self-Magnetic Field (T) | 2.5 | 2.5 | 2.5 |
| Backup Magnetic Field (T) | 21.0 | 21.0 | 21.0 |
| Coil Current Density (A/mm²) | >100 | >100 | >100 |

| Wire | | | |
|---|---|---|---|
| Structure | HoBCO Tape Wire | Bi-based Wire (Bi-2212 Wire) | HoBCO Tape Wire |
| Dimension | 0.1 mm × 5 cm width | 2.0 mm diameter | 0.1 mm × 1 cm width |
| Unit Length (m) | 10 (20 unit lengths) | 1,600 (1 unit length) | 500 (1 unit lengths) |
| Ic (A) (4.2K, 25 T) | >800 | >300 | >800 |

### (Evaluation Results)

As shown in Table 1, the superconducting coil of Reference Example 1 could be formed from superconducting tape wires having a small unit length of 10 m/layer. When a current of 160 A was applied to each divided region of a 1-cm width formed in the superconducting layer in the machining step (S20), the passed current amounted to 800 A in total of the five regions.

Furthermore, required specification for the superconducting layer was degraded, and hence manufacturing cost of the superconducting coil of Reference Example 1 could be reduced.

In addition to the case in which currents were applied in parallel to the five divided regions each having a width of 1 cm by respective five electrical sources, series current application was performed in series connection (five regions being connected in series) by using one electrical source. As a result, it was proved that a current of 800 A passed in both cases.

On the other hand, in the case of the superconducting coil of Comparative Example 1, a very long wire having a unit length of 1,600 m had to be used, since the coil was formed using a Bi-based wire having a round shape.

In the case of Comparative Example 2, a long wire having a unit length of 500 m was needed, although the length of the required wire was smaller as compared with Comparative Example 1 since the wire was made of a tape-shaped HoBCO film having a width of 1 cm.

### Example 2

### (Formation of Superconducting Coil in Example 2)

In Example 2, a superconducting coil was formed in accordance with the manufacturing method described in Embodiment 2. In particular, for the superconducting coil of Example 2, the step (S10) of preparing a tape substrate and the step (S20) of forming an intermediate thin layer on the tape substrate were performed. The tape substrate and the intermediate thin layer used in the steps (S10 and S20) were similar to those described in Reference Example 1.

Next, the machining step (S50) was performed in which at least one intermediate-layer parting region was to be formed extending from the one-end portion to the other-end portion in the intermediate thin layer extending from the one-end portion to the other-end portion. In this step (S50), the intermediate thin layer was irradiated with a YAG laser so that the intermediate-layer parting regions were formed.

Next, the step (S30) of forming the superconducting layer was performed. In this step (S50), the intermediate thin layer was irradiated with a YAG laser so that the intermediate-layer parting regions were formed.

Next, a step (S60) of winding the superconducting tape wire was performed. Consequently, a superconducting coil having one layer as shown in Example 2 in the following Table 2 was formed.

### (Formation of Superconducting Coil in Reference Example 3)

As for the superconducting coil of Reference
Example 3, a superconducting coil having one layer as shown in the following Table 2 was formed using the superconducting tape wire of Reference Example 1.

**[Table 2]**

| | Example 2 | Reference Example 3 |
|---|---|---|
| Coil | | |
| Inner diameter (mm) | 75 | 75 |
| Outer diameter (mm) | 80 | 80 |
| Length (mm) | 600 | 600 |
| Number of Turns | 60 | 60 |
| Number of Layers | 1 | 1 |
| Current (A) | 200 × 5 lines Series Connection | 200 × 5 lines Series Connection |
| Self-Magnetic Field (T) | 0.15 | 0.15 |

| Wire | | |
|---|---|---|
| Structure | HoBCO Tape Wire (of Embodiment 2) | Bi-based Wire (of Embodiment 1) |
| Dimension | 0.1 mm × 5 cm width | 0.1 mm × 5 cm width |
| Unit Length | 10 | 10 |
| Ic (A) (4.2K, 25 T) | >1,200 | >1,200 |

### (Evaluation Results)

In the superconducting tape wire used for the superconducting coil of Example 2, the state in which the crystallinity was disordered in the intermediate-layer parting region was generated by means of YAG laser irradiation. Consequently, the superconducting layer on the intermediate-layer parting region was caused to have an amorphous state or insufficient in-plane crystallinity, and hence the superconducting state was not obtained. Accordingly, when current is applied to the superconducting coil of Example 2, a superconducting layer on the portion which is an intermediate-layer parting region of the intermediate thin layer did not come to a superconducting state although a superconducting layer on the portion which is a region other than the intermediate-layer parting region in the intermediate thin layer became superconductive.

As shown in Table 2, the performance of the superconducting coil formed in Example 2 (in which the superconducting tape wire formed in Embodiment 2 was used) was equivalent to that of the superconducting coil formed in Reference Example 3 (in which the superconducting tape wire formed in Embodiment 1 was used). Hence, the effects of the superconducting coil and the manufacturing method thereof, according to Embodiment 2 of the present invention, were confirmed.

### Industrial Applicability

According to the method for manufacturing a superconducting tape wire of the present invention, at least one parting region or intermediate-layer parting region is formed. Accordingly, a wide superconducting tape wire with a relatively small length can easily be manufactured such that the superconducting tape wire has an effect similar to that of a long wire. In addition, with such a wide superconducting tape wire having substantially the same effect as a long wire, a superconducting apparatus having substantially the same effect as a superconducting apparatus using a long wire can be manufactured at a reasonable cost.

## Claims

1. A method for manufacturing a tape wire (10, 30), comprising:
- (S10) a step of preparing a tape substrate (11, 31);
- (S20) a step of forming an intermediate thin layer (12, 32) on the tape substrate (11, 31); and
- (S30) a step of depositing a high-temperature superconducting material on the intermediate thin layer (12, 32) for forming a superconductive layer (13, 33) for attaining a superconducting state at a critical temperature,
**characterized by**
- (S40, S50) a machining step of forming at least one portion in which the superconductive layer is not present extending from a one-end portion (13c, 32c) to an other-end portion (13d, 32d), wherein said end portions are ends of the superconducting layer on the intermediate thin layer.

## Patentansprüche

1. Verfahren zur Herstellung eines Banddrahtes (10, 30), umfassend:
- (S10) einen Schritt des Vorbereitens eines Bandsubstrats (11, 31),
- (S20) einen Schritt des Bildens einer intermediären Dünnschicht (12, 32) auf dem Bandsubstrat (11, 31) und
- (S30) einen Schritt des Ablagerns eines hochtemperatursupraleitenden Materials auf der intermediären Dünnschicht (12, 32) zum Bilden einer supraleitenden Schicht (13, 33), um einen supraleitenden Zustand bei einer kritischen Temperatur zu erreichen,
**gekennzeichnet durch**
- (S40, S50) einen Bearbeitungsschritt des Ausbildens wenigstens eines Abschnitts, in welchem die supraleitende Schicht nicht vorhanden ist und welcher sich von einem Abschnitt (13c, 32c) an einem Ende zu einem Abschnitt (13d, 32d) am anderen Ende erstreckt, wobei die Endabschnitte Enden der supraleitenden Schicht auf der intermediären Dünnschicht sind.

## Revendications

1. Procédé de fabrication d'un fil de bande (10, 30), comprenant :
- (S10) une étape de préparation d'un substrat de bande (11, 31) ;
- (S20) une étape de formation d'une mince couche intermédiaire (12, 32) sur le substrat de bande (11, 31) ; et
- (S30) une étape de dépôt d'un matériau supraconducteur à haute température sur la mince couche intermédiaire (12, 32) pour former une couche supraconductrice (13, 33) pour atteindre un état supraconducteur à une température critique,
**caractérisé par**
- (S40, S50) une étape d'usinage formant au moins une portion dans laquelle la couche supraconductrice n'est pas présente s'étendant à partir d'une portion d'une extrémité (13c, 32c) jusqu'à une portion d'une autre extrémité (13d, 32d), où lesdites portions d'extrémité sont des extrémités de la couche supraconductrice sur la mince couche intermédiaire.
